# EUROPEAN PATENT SPECIFICATION

(11) **EP 1 023 638 B1**
(45) Date of publication and mention of the grant of the patent: **21.04.2004**
(21) Application number: 98950562.3
(22) Date of filing: 13.10.1998
(51) Int. Cl.: G03F 7/20, H04N 1/04

(54) **APPARATUS FOR A LASER WRITER FOR COMPLEX MICROLITHOGRAPHIC PATTERNS WITH A DELAY CIRCUIT**
APPARAT IN EINEM LASER-BELICHTUNGSGERÄT FÜR KOMPLEXE MIKROLITHOGRAPHIEMUSTER MIT EINEM VERZÖGERUNGSSCHALTKREIS
APPAREIL DESTINE A UN DISPOSITIF D'ECRITURE LASER POUR MOTIFS MICROLITHOGRAPHIQUES COMPLEXES ET DOTE D'UN CIRCUIT A RETARD

(30) Priority: 13.10.1997 SE 9703700
(43) Date of publication of application: 02.08.2000
(73) Proprietor: MICRONIC LASER SYSTEMS AB, S-18303 Täby (SE)
(72) Inventor: SANDSTRÖM, Torbjörn, S-435 43 Pixbo (SE); ODSELIUS, Leif, S-194 38 Upplands Väsby (SE)
(74) Representative: Lindberg, Klas Valter Bo
(86) International application number: PCT/SE1998/001835
(87) International publication number: WO 1999/019772

(56) References cited:
- US-A- 4 549 222
- US-A- 5 635 976

## Description

### Field of the invention

The invention relates to a method and an apparatus for producing microlithography, in particular to the writing of photomasks for and direct writing of computer displays, microelectronic devices, and precision photo-etching, with the use of a time delay circuit such as is known from European Patent EP 0 467 076, for example. It is also applicable to optical devices and a variety of electronic interconnection structures such as multichip modules. Other applications are possible, such as printing and graphics, as well as laser projection displays.

### Background of the invention

There is a development towards an ever-increasing number of features on photomasks, and increasingly sophisticated designs. For both computer displays, consumer TV screens and microelectronic products there is a rapid development towards at the same time larger sizes and smaller elemental cells. The development is most dramatic with semiconductor memories where a photomask could contain a billion elemental geometries or more.

Another issue is the necessity of a small address grid. The writing system for semiconductor masks must be capable of writing features specified in units of 10 nm (nanometers) or less. It has been disclosed in European Patent EP 0 467 076 by the same applicant that a combination of time delays and analog power modulation can be used to achieve an arbitrarily small address grid. The same patent also discloses the use of several beams and parallel data paths to increase the through-put of the writing system.

Naturally there is hereby a need for a very exact and reliable time delay circuit, something which has been a problem in the prior art which uses integrating delay circuits, creating the delay as the time needed to change an integrating capacitor to a determined level. There is also a problem with synchronization between the delay circuit and the clock pulse generator, and with complicated and time-consuming tuning adjustments, that is necessary in every new installation, and also when there have been changes in the clock rate etc.

Further these known delay circuits are not fast enough in changing the time value, leading to a deterioration of the performance of the apparatus. The known delay circuits are also sensitive to interference.

It is therefore an object with the present invention to provide an apparatus of the above mentioned type with an improved delay circuit.

This object is fulfilled with an apparatus according to claim 1. Other features and advantages with the present invention will be appreciated from the dependent claims, and from the following detailed description of a preferred embodiment of the invention with reference to the attached drawings.

### Brief summary of the invention

The present invention relates to a method and apparatus for writing of lithographic patterns with raster scanning technique comprising the use of an electronic clock to control the modulation of the beam where the placement in the scanning directions of pattern elements is controlled by time delays of at least one clock signal by fractions of a clock period. The invention is characterised in that said clock period is divided into a number of equally spaced time values by means of a delay-locked loop and a particular time value is chosen according to a digital control word. Hereby several advantages are obtained, such as no need for tuning adjustments, an automatical adjustment to the clock and stability against interference.

According to a preferred embodiment of the invention the delay circuit comprises N delay elements, each providing an additional delay of 1/N of the clock period, whereby N is digitally adjustable between at least two predetermined values, preferably 50, 60 and 64. Hereby the clock period can be exactly divided by several different numbers, diminishing the problem with rounding errors.

According to another preferred embodiment of the invention the delay circuit comprises N delay elements, where N is a number such that N = 2ⁿ when n is an positive integer, whereby any time period can be digitally represented by a binary word for the number of complete clock periods and a binary word for the additional delay as a number of 1/N fractions of a clock period. Hereby any period of time becomes very easy to state and communicate.

According to another preferred embodiment of the present invention the delay circuit is used for providing an address resolution significantly higher than what is given by the electronic clock, by time delay in the respective clock periods.

According to still another preferred embodiment of the invention the delay circuit is used to delay the input clock signal of the electronic clock for certain logic components, such as components for adjusting the beam relative to other beams in the case of multiple beam writing, or components for fine adjustment of the placement of the whole pattern in the scanning direction.

### Brief description of the drawings

Figure 1 shows an apparatus for producing a surface pattern or structure according to the prior art.
Figure 2 shows an embodiment of a modulator driver logic that can be used in the apparatus of fig 1.
Figure 3 shows the delay circuit to be used in the invention according to a prefered embodiment.
Figure 4 shows a time chart illustrating the operation for the delay circuit in fig 3.
Figure 5 shows another embodiment of the delay circuit according to the invention.

### Preferred embodiments

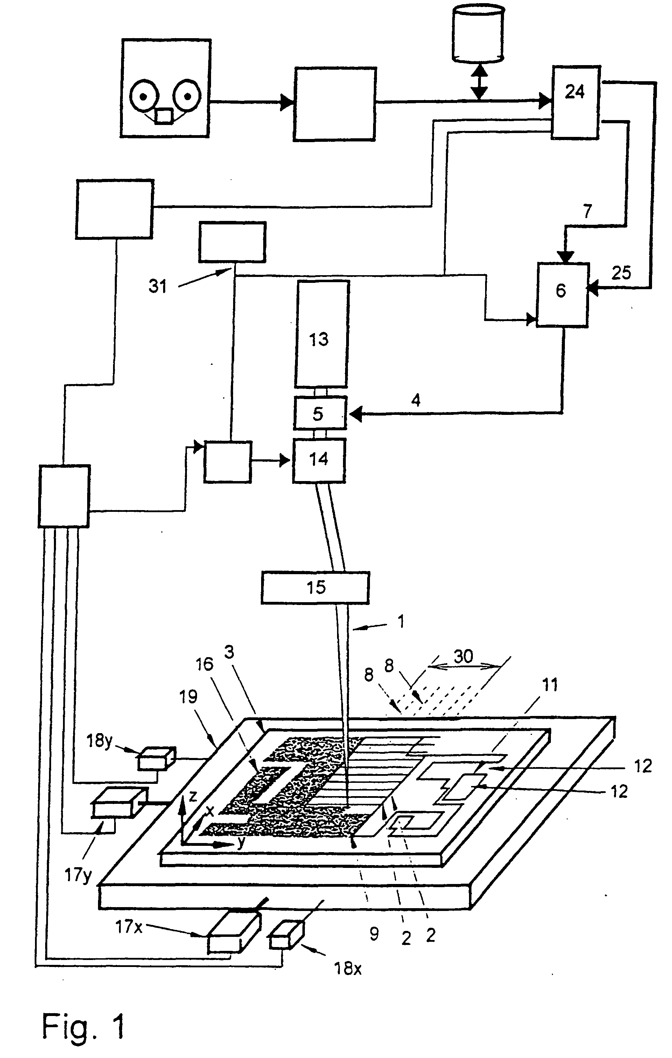

Reference will now be made to Fig. 1 showing an apparatus according to the prior art for producing surface patterns or structures on photosensitively coated supports or substrates. In the illustrated embodiment, the substrate 3 is disposed on an object table 19 which is movable in the X- and Y-directions. A writing head with a focusing lens 15 and a deflector device 14 is arranged to be stationary in the X- and Y-directions.

A laser beam source 13 produces a laser beam which is modulated in regard to its power and in particular its intensity by a modulator device 5. The focusing lens 15 focuses on the laser beam and forms a focused laser beam as indicated at 1, which is directed on to the surface of the substrate 3.

For monitoring the positioning of the object table 19, the apparatus has position monitoring devices 18x and 18y which monitor the positioning of the object table 19 in the X- and Y-directions relative to the writing head (deflector device 14 and focusing lens 15). Together with electric motors 17x and 17y, the position monitoring devices 18x and 18y form a servo mechanism which produces the precisely controlled movement of the object table 19.

The servo mechanism produces stripes 30 of a given width when the laser beam 1 scans along the scan lines 2 in the X-direction at a constant speed. When a respective stripe 30 is completed, the X-servo mechanism performs a retrace stroke movement into the starting position and the object table 19 is then moved in the Y-direction by the width of a stripe by the electric motor 17y.

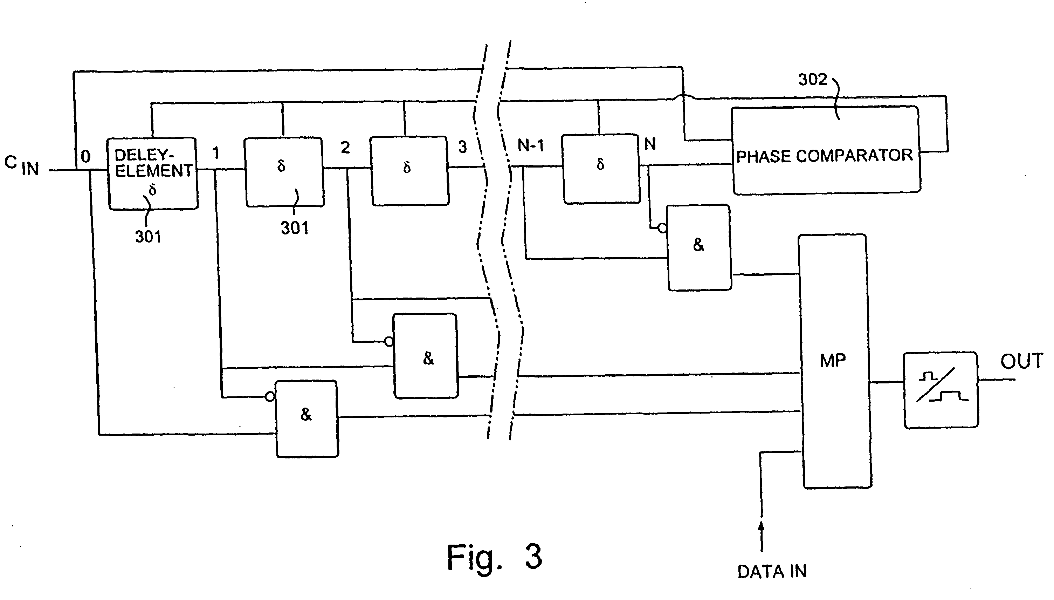

The laser beam from the source 13 is passed through the acousto-optical modulator 5 which is actuated by a high-frequency modulation drive signal 4. The modulation drive signal 4 is supplied by the modulator driver logic means 6. The intensity or power of the modulation drive signal 4 is controlled by an analog modulation drive signal of a digital-analog converter. The digital-analog converter which is disposed in the modulator driver stage or logic means 6, as shown in Fig. 3, is controlled by a power control signal 7 by way of a storage device which is preferably in the form of a register, for storage of the digital power control word required for producing the control effect.

Generally, the data delivery means includes a clock having a predetermined clock period between clock pulses, so as to establish a regular train of clock pulses. A data processing unit is provided for accepting input data and computing or establishing beam intensity data and beam position data for an edge in the pattern to be written. Both the beam intensity data and the beam position data are established in a digital format. The apparatus also includes as part of the data delivery means a signal processing unit for converting the beam position data to an equivalent time for positioning the laser beam along the scan line during scanning. Particularly, this equivalent time is converted as an integer number of clock pulses plus a fractional remainder. To create a time pulse corresponding to the equivalent time, digital counting means may be provided for generating a timing pulse at a time corresponding to the integer number of clock pulses and a time delay circuit may be provided for incurring to the timing pulse a time delay equal to the fractional remainder. Once the corresponding time pulse is created, a circuit may be used for setting the modulator input signal to the digital beam intensity data at the arrival of the timing pulse.

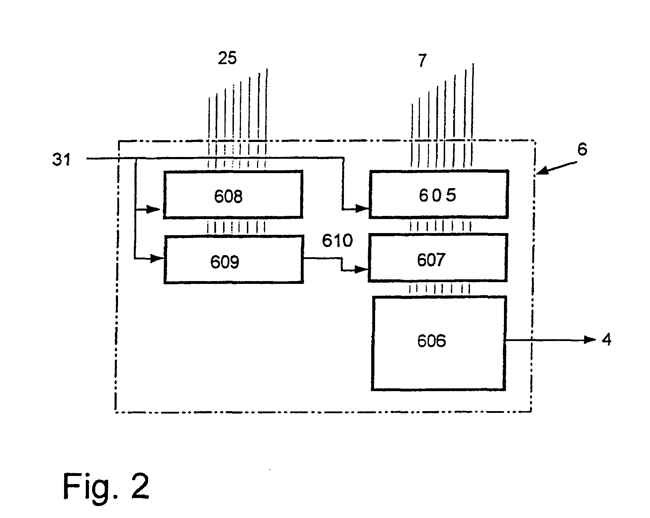

Reference will be made at this point to Fig. 2 showing a preferred embodiment of the modulator drive logic means 6 described above with reference to Fig. 1. It has two storage devices for bit words, in the form of registers 605 and 608. The register 605 is loaded with intensity or power data 7 coming from the data delivery device 24 shown in Fig. 1. The register 608 is loaded with position or delay data 25 which also come from the data delivery device 24. That takes place on the basis of a transition caused by the clock signal 31. In that arrangement, a digital-analog converter 606 is also operated by power data previously stored in the storage device 607. It may also be in the form of a register. A digitally controlled delay circuit 609 transfers the clock signal 31 to its output side, with a delay which depends on the data stored in the register 608. After that delay the active edge of the clock signal is supplied at the output 610 of the delay circuit 609. The value stored in the register 605 is loaded into the register 607 and passed to the input side of the digital-analog converter 606. After an internal delay in the digital-analog converter 606, a fresh analog power control signal 4 occurs at the output of the modulator driver stage of the modulator device 5 (fig. 1).

In the prior art the delay circuits were digitally controlled analog delay circuits. These analog delay circuits have several drawbacks. For example the minimum time step is comparatively large, there is a strong need for individual adjustments to the clock, the latency period is significantly large, whereby there is a need for several delay circuits working by turns, there is a large sensitivity for external disturbances and the speed is very limited.

In fig 3 there is shown a delay circuit according to the present invention. The delay circuit comprises a delayed-locked-loop, which in turn comprises N serially connected delay elements 301, where N is an integer larger than two. Each delay elements delays a reference signal from the clock, with a quantum of time. This quantum of time is preferably the same for all the elements, i.e. 1/N of a clock period. Naturally the delay circuit can also comprise several delayed-locked loops.

The circuit also comprises a phase comparator 302 connected to the output of the last delay element for receiving the routed delayed signal and the reference signal from the clock. Thereby the phase comparator 302 generates a control signal indicative of a difference between a phase of said routed delay signal and a phase of said reference signal. The output of the phase comparator is connected to said delay elements for transferring the control signal to the delay elements whereby each of the delay elements adjusts such that the phase of said reference signal is synchronized with the phase of said routed delay signal. That is, the delay circuit comprises a feedback system which automatically adjusts the amount of delay in each delay step.

Circuits using the delayed-locked-loop technique is known from e.g. US patent 4 338 569. These known circuits have been used in completely different areas, though: adjustment of clock skew and time measurements (mainly in the area of nuclear physics and the like).

The delay circuit of the invention also comprises a selecting part, preferably comprising a multiplexer 303 being connected to the delay elements for receiving the delayed signals generated by the delay elements 301 and to control the output of the delay circuit according to the desired fractional remainder.

To the input of the multiplexer 303 are connected the output signal from the respective delay elements. This is preferably accomplished with NAND-gates 304, such that the signal before and after each delay element 301 are connected to a NAND-gate 304, the output of which is forwarded to the multiplexer 303. In this way the input signals to the multiplexer 303 are very short pulses.

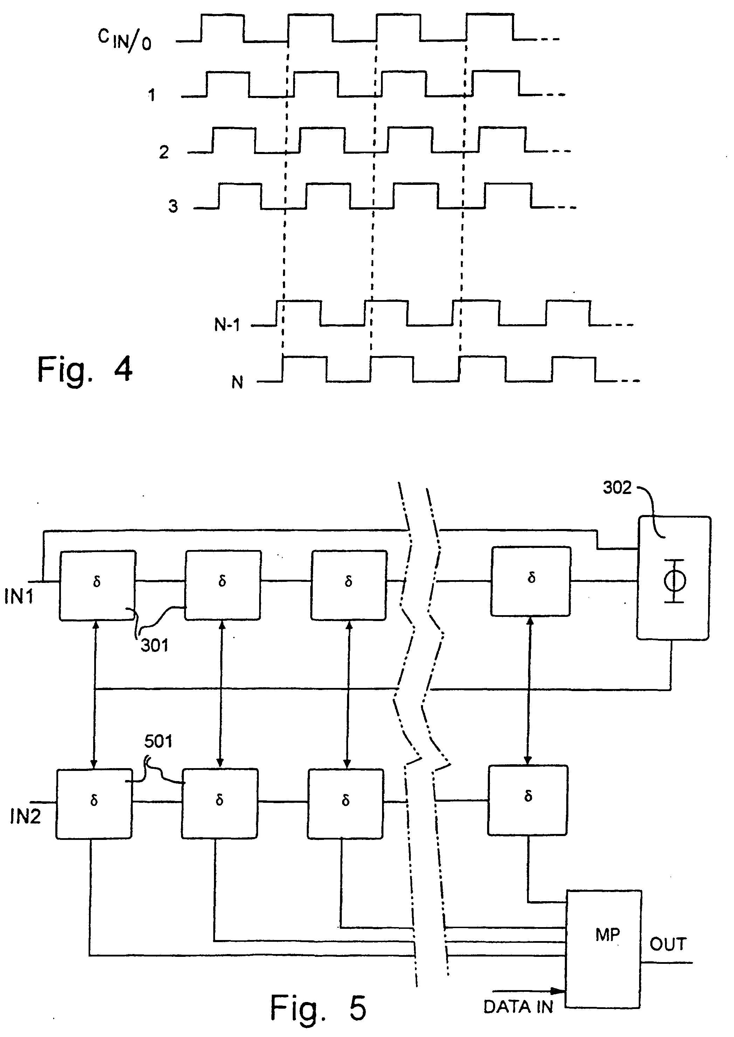

The signals between the different delay elements are illustrated in the time chart in fig 4.

The multiplexer also have a control word as input, and according to this control word the correct output is chosen. The multiplexer according to the invention preferably have a disable function, whereby a disable signal at a disable input can prevent any signal at the output. This is important in order to suppress a delay signal from the delay circuit, to e.g. prevent delayed signals from entering the next clock period, and so forth.

The output from the multiplexer 303 is preferably forwarded through a pulse stretcher 305. The pulse stretcher makes the output pulses from the delay circuit longer in time. This reduces the sensitivity to noise.

The delay value can be dynamically set by a delay control input (control word) to any value between 0 and N-1. N is preferably a number such that N = 2ⁿ where n is an positive integer. Hereby any time period can be digitally represented by a binary word for the number of complete clock periods and a binary word for the additional delay as a number of 1/N fractions of a clock period.

Further, N is preferably controlled by an input port and can be optionally set to any of the values 50, 60 or 64. The set input is not shown in picture 1. Hereby the clock period can be exactly divided by 2, 3, 4, 5, 6, 8, 10, 12, 15, 16, 20, 25, 30, 32, 50, 60 and 64. Possibly the value can also be set to 72, and thereby provide for an exact division by 9, 18, 24, 36 and 72. This is of great importance in avoiding rounding errors. Other values that can be used for N are: 25, 30, 32, 36, 40, 72, 80, 100, 120 and 128. Still further values are naturally possible, as long as they provide for an exact division by numbers that are useful for the intended application, and preferably several different such numbers.

The circuit is preferably designed with Emitter Coupled Logic (ECL) technology.

In fig 5 there is shown an alternative embodiment of the delay circuit according to the invention. The delay circuit of this embodiment also comprises a delay-locked loop with serially connected delay elements 301 and a phase comparator 302. However, the delay circuit according to this embodiment comprises a second set of serially connected delay elements 501, whereby the control signal from the phase comparator 302 is not only sent back to the delay elements 301 in the first set but also to the delay elements 501 in the second set. With this arrangement the delay elements 501 in the second set will have the same delay time values as the delay elements 301 in the first set (e.g. 2 ns per element). With this embodiment the first set may have a first input, IN1, and the second set another input, IN2. Hereby there is a possibility to delay the second input signal, which may be asynchronous with the first input signal (e.g. the clock signal), with delay time values that are automatically adjusted to the first input signal.

The delay circuit according to the invention provides several advantages over the prior art, such as:
- more stable and robust against interference;
- no need for tuning adjustments;
- automatically adjusts to the clock;
- can be made very compact;
- digitally controlled division;
- higher clock frequency;
- no latency or waiting periods in e.g. capacitors.

For example, a clock with 50 Mhz provide a clock period T = 20 ns. If this period is to be divided by 60, the result is 333 ps per step. An expected deviation for the circuit according to the invention is about +/- 170 ps, compared to +/- 1000 ps for analog circuits. This clearly illustrates the diminished need for tuning adjustments with the circuit according to the invention.

The delay circuit of the invention accordingly provides a very exact division of the clock pulses, thereby producing a very exact time delay. The circuit also adapts to the clock signal, and is therefore always synchronized with the clock.

The delay circuit described above may also be used for other purposes in the writing of lithographic patterns with raster scanning technique. The delay circuit may be used to delay the input clock signal of the electronic clock for certain logic components, such as components for adjusting the beam relative to other beams in the case of multiple beam writing, or components for fine adjustment placement of the whole pattern in the scanning direction.

The terms and expressions which have been employed in the foregoing specification are used therein as terms of description and not of limitation, and there is no intention in the use of such terms and expressions of excluding equivalents of the features shown and described or portions thereof, it being recognized that the scope of the invention is defined and limited only by the claims which follow.

## Claims

1. Method for writing of lithographic patterns with raster scanning technique comprising the use of an electronic clock to control the modulation of the beam where the placement in the scanning directions of pattern elements is controlled by time delays by fractions of a clock period, **characterised in that** said clock is used to generate a number of preferably equally spaced delay time values by means of a delay-locked loop and a particular delay time value is chosen according to a digital control word.

2. Method according to claim 1, where the digital control word is changed dynamically during the writing of a pattern.

3. Method according to claim 1 or claim 2, **characterised in that**
said time delay circuit comprises a delayed-locked-loop, comprising:
at least N serially connected delay elements, where N is an integer larger than two, each delaying a reference signal from said clock, with a quantum of time, and
a phase comparator connected to the output of the N:th delay element for receiving the routed delayed signal and the reference signal, for generating a control signal indicative of the difference between a phase of said routed delay signal and a phase of said reference signal, and feedback means for transferring the control signal to the delay elements whereby each of the delay elements adjusts such that the phase of said reference signal is synchronized with the phase of said routed delay signal.

4. Method according to one of claims above, **characterised in that** said time delays are generated by a number of serially connected delay elements controlled by the control signal in the delayed-locked loop.

5. Method according to claim 3, **characterised in that** the clock signal is connected to serially connected delay elements controlled by said control signal and selecting a number of delay elements to delay said clock signal to the output according to said digital control word.

6. Method according to one of the claims above, **characterised in that** the delay circuit comprises N delay elements, each providing an additional delay of 1/N of the clock period, whereby N is digitally adjustable between at least two predetermined values, preferably chosen among the values 25, 30, 32, 36, 40, 50, 60, 64, 72, 80, 100, 120 and 128.

7. Method according to one of the claims above, **characterised in that** the clock period is divided in N increments (steps), where N is a number such that N = 2ⁿ when n is a positive integer, whereby any time period can be digitally represented by a binary word for the number of complete clock periods and a binary word for the additional delay as a number of 1/N fractions of a clock period.

8. Method according to one of the claims 1 to 7, **characterised in that** the delay circuit is used for providing an address resolution for pattern elements significantly higher than what is given by the electronic clock, by time delay in the respective clock periods.

9. Method according to one of the claims 1 to 7, **characterised in that** the delay circuit is used to delay the input clock signal of the electronic clock for certain logic components.

10. Method according to claim 9, **characterised in that** the logic components are components for adjusting the beam relative to other beams in the case of multiple beam writing.

11. Method according to claim 9, **characterised in that** the logic components are components for fine adjustment placement of the whole pattern in the scanning direction.

12. An apparatus adapted for writing of lithographic patterns with raster scanning technique, comprising an electronic clock and a time delay circuit, **characterised in that** the time delay circuit is a delayed-locked-loop circuit, driven by the said clock, whereby the output from the delay circuit is determined by input data.

13. An apparatus according to claim 12, whereby it is intended for writing of complex patterns on a light sensitive surface by scanning at least one, by a modulator modulated, laser beam in parallel scan lines while moving along scan stripes in a direction perpendicular to the scan lines, the apparatus comprising:
data delivery means for controlling the input of said modulator while the laser beam is scanning, wherein the.data delivery means includes
a clock with a predetermined clock period between the clock pulses;
a data processing unit for receiving input data and computing beam intensity data and beam position data each in digital format, for an edge in the pattern,
a signal processing unit for converting the beam position data to an equivalent time for positioning the laser beam along the scan line during scanning, and converting this equivalent time to an integer number of clock pulses plus a fractional remainder, and
a time delay circuitry to delay transition in the modulated data, producing said fractional remainder, for higher address resolution than corresponding to the data clock pulses.

14. An apparatus according to claim 12 or 13, **characterised in that**
said time delay circuit comprises a delayed-locked-loop, comprising:
N serially connected delay elements, where N is an integer larger than two, each delaying a reference signal from said clock, with a quantum of time,
a phase comparator connected to the output of the N:th delay element for receiving the routed delayed signal and the reference signal, for generating a control signal indicative of a difference between a phase of said routed delay signal and a phase of said reference signal, and being feedback connected to said delay elements for transferring the control signal to the delay elements whereby each of the delay elements adjusts such that the phase of said reference signal is synchronized with the phase of said routed delay signal,
a multiplexer being connected to the delay elements for receiving the delayed signals generated by the delay elements and to control the output of the delay circuit according to the desired fractional remainder.

15. An apparatus according to one of claim 12-14, **characterised in that** said time delays are generated by a number of serially connected delay elements controlled by the control signal in the delayed-locked loop.

16. An apparatus according to claim 14, **characterised in that** the each delaying element delays the reference signal from said clock, with a quantum of time being 1/N of a clock period.

17. An apparatus according to one of claim 12-16, **characterised in that** the delay circuit comprises N delay elements, each providing an additional delay of 1/N of the clock period, whereby N is digitally adjustable between at least two predetermined values, preferably chosen among the values 25, 30, 32, 36, 40, 50, 60, 64, 72, 80, 100, 120 and 128.

18. An apparatus according to one of claim 12-17, **characterised in that** the delay circuit is produced with ECL (Emitter Coupled Logic) technology.

19. An apparatus according to one of claim 12-17, **characterised in that** the delay circuit is produced with CMOS (Complementary Metal-Oxide Semiconductor) technology.

20. An apparatus according to one of claim 12-19, **characterised in that** the apparatus provides an address resolution in pattern elements significantly higher than what is given by the electronic clock by means of a time delay from said delay circuit in the respective clock periods.

21. An apparatus according to one of claim 12-19, **characterised in that** the apparatus is a multi-beam writer, where the delay circuit is adapted to delay the input clock signals of the electronic clock for adjusting a beam relative to the other beams.

22. An apparatus according to one of claim 12-19, **characterised in that** the delay circuit is used to delay the input clock signals of the electronic clock for fine adjustment of the placement of the whole pattern in the writing direction.

## Patentansprüche

1. Verfahren zum Schreiben von lithographischen Mustern mit Rasterabtasttechnik, unter Verwendung eines elektronischen Taktgebers zum Steuern der Modulation des Strahls, wobei die Platzierung von Musterelementen in den Abtastrichtungen durch Zeitverzögerungen um Bruchteile einer Taktperiode gesteuert wird, **dadurch gekennzeichnet, dass** der Taktgeber eingesetzt wird, um eine Anzahl von vorzugsweise gleichmäßig beabstandeten Verzögerungszeitwerten mittels einer verzögert-verriegelten Schleife zu erzeugen, und dass ein bestimmter Verzögerungszeitwert entsprechend einem digitalen Steuerbefehl ausgewählt wird.

2. Verfahren nach Anspruch 1, **dadurch gekennzeichnet, dass** der digitale Steuerbefehl während des Schreibens eines Musters dynamisch verändert wird.

3. Verfahren nach Anspruch 1 oder 2, **dadurch gekennzeichnet, dass** der Zeitverzögerungs-Schaltkreis eine verzögert-verriegelte Schleife besitzt, aufweisend:
wenigstens N seriell verbundene Verzögerungselemente, wobei N eine ganze Zahl größer als 2 ist, die jeweils ein Referenzsignal des Taktgebers um ein Zeitquantum verzögern, und
einen mit dem Ausgang des N-ten Verzögerungselements zum Empfangen des weitergeleiteten, verzögerten Signals und des Referenzsignals verbundenen Phasenvergleicher zum Erzeugen eines Steuerungssignals, das indikativ für den Unterschied zwischen einer Phase des weitergeleiteten Verzögerungssignals und einer Phase des Referenzsignals ist, und Rückkopplungsmittel zum Übertragen des Steuerungssignals zu den Verzögerungselementen, wodurch jedes der Verzögerungselemente so angepasst wird, dass die Phase des Referenzsignals mit der Phase des weitergeleiteten Verzögerungssignals synchronisiert wird.

4. Verfahren nach einem der vorangehenden Ansprüche, **dadurch gekennzeichnet, dass** die Zeitverzögerungen durch eine Anzahl von seriell verbundenen Verzögerungselementen erzeugt werden, die durch das Steuerungssignal in der verzögert-verriegelten Schleife gesteuert werden.

5. Verfahren nach Anspruch 3, **dadurch gekennzeichnet, dass** das Taktsignal mit seriell verbundenen Verzögerungselementen verbunden ist, die durch das Steuerungssignal gesteuert werden, und dass eine Anzahl von Verzögerungs-elementen ausgewählt wird, um das Taktsignal zum Ausgang gemäß der digitalen Steuerbefehl zu verzögern.

6. Verfahren nach einem der vorangehenden Ansprüche, **dadurch gekennzeichnet, dass** der Verzögerungsschaltkreis N Verzögerungselemente aufweist, die jeweils eine zusätzliche Verzögerung um 1/N-tel der Taktperiode bewirken, wobei N digital zwischen wenigstens zwei vorbestimmten Werten einstellbar ist, die vorzugsweise aus den Werten 25, 30, 32, 36, 40, 50, 60, 64, 72, 80, 100, 120 und 128 ausgewählt werden.

7. Verfahren nach einem der vorangehenden Ansprüche, **dadurch gekennzeichnet, dass** die Taktperiode in N Erhöhungen (Schritte) unterteilt wird, wobei N eine Zahl ist, so dass N = 2ⁿ, wenn es sich bei n um eine positive ganze Zahl handelt, wobei jegliche Zeitperiode digital durch ein binäres Wort für die Anzahl vollständiger Taktperioden und ein binäres Wort für die zusätzliche Verzögerung als eine Anzahl von 1/N-Bruchteilen einer Taktperiode dargestellt werden kann.

8. Verfahren nach einem der Ansprüche 1 bis 7, **dadurch gekennzeichnet, dass** der Verzögerungs-Schaltkreis durch Zeitverzögerung in den entsprechenden Taktperioden zum Bereitstellen einer Adressauflösung für Musterelemente benutzt wird, die signifikant höher ist als diejenige des elektronischen Taktgebers.

9. Verfahren nach einem der Ansprüche 1 bis 7, **dadurch gekennzeichnet, dass** der Verzögerungs-Schaltkreis zum Verzögern des Eingangs-Taktsignals des elektronischen Taktgebers für bestimmte logische Komponenten verwendet wird.

10. Verfahren nach Anspruch 9, **dadurch gekennzeichnet, dass** es sich bei den logischen Komponenten um Komponenten zum Einstellen des Strahls relativ zu anderen Strahlen im Falle eines Schreibens mit Mehrfachstrahlen handelt.

11. Verfahren nach Anspruch 9, **dadurch gekennzeichnet, dass** es sich bei den logischen Komponenten um Komponenten zum fein eingestellten Platzieren des gesamten Musters in der Abtastrichtung handelt.

12. Vorrichtung zum Schreiben lithographischer Muster mit Rasterabtasttechnik mit einem elektronischen Taktgeber und einem Zeitverzögerungs-Schaltkreis, **dadurch gekennzeichnet, dass** der Zeitverzögerungs-Schaltkreis ein verzögert-verriegelter Schleifen-Schaltkreis ist, der durch den Taktgeber getrieben ist, wobei die Ausgabe des Verzögerungs-Schaltkreis es durch Eingangsdaten bestimmt ist.

13. Vorrichtung nach Anspruch 12, die zum Schreiben komplexer Muster auf einer lichtempfindlichen Fläche durch Abtasten mit wenigstens einem mittels eines Modulators modulierten Laserstrahls in parallelen Abtastlinien während einer Bewegung entlang Abtaststreifen in einer Richtung senkrecht zu den Abtastlinien vorgesehen ist, aufweisend:
Datenliefermittel zum Steuern des Eingangs des Modulators während der Laserstrahl abtastet, wobei die Datenliefermittel beinhalten:
einen Taktgeber mit einer vorbestimmten Taktperiode zwischen den Taktpulsen;
eine Datenverarbeitungseinheit zum Empfangen von Eingangsdaten und zum Berechnen von Strahlintensitäts-Daten und Strahlpositions-Daten jeweils in digitalem Format für einen Rand in dem Muster,
eine Signalverarbeitungseinheit zum Umwandeln der Strahlpositions-Daten in eine äquivalente Zeit zum Positionieren des Laserstrahls entlang der Abtastlinie während des Abtastens und zum Konvertieren der äquivalenten Zeit in eine ganzzahlige Anzahl von Taktpulsen und einen gebrochenen Rest, und
eine Zeitverzögerungs-Elektronik zum Verzögern eines Übergangs in den modulierten Daten, die den gebrochenen Rest erzeugt, für eine höhere Adressauflösung als im Falle der Daten-Taktpulse.

14. Vorrichtung nach Anspruch 12 oder 13, **dadurch gekennzeichnet, dass** die Zeitverzögerungs-Elektronik eine verzögert-verriegelte Schleife besitzt, aufweisend:
N seriell verbundene Verzögerungselemente, wobei N eine ganze Zahl größer als 2 ist, die jeweils ein Referenzsignal des Taktgebers um ein Zeitquantum verzögern,
einen mit dem Ausgang des N-ten Verzögerungselements zum Empfangen des weitergeleiteten, verzögerten Signals und des Referenzsignals verbundenen Phasenvergleicher zum Erzeugen eines Steuerungssignals, das indikativ für den Unterschied zwischen einer Phase des weitergeleiteten Verzögerungssignals und einer Phase des Referenzsignals ist, der zu Rückkopplungszwecken zum Übertragen des Steuerungssignals mit den Verzögerungselementen verbunden ist, wodurch jedes der Verzögerungselemente so angepasst wird, dass die Phase des Referenzsignals mit der Phase des weitergeleiteten Verzögerungssignals synchronisiert ist,
einen Multiplexer, der mit den Verzögerungselementen zum Empfangen der durch die Verzögerungselemente erzeugten verzögerten Signale und zum Steuern des Ausgangs des Verzögerungsschaltkreises gemäß dem gewünschten gebrochenen Rest verbunden ist.

15. Vorrichtung nach einem der Ansprüche 12 bis 14, **dadurch gekennzeichnet, dass** die Zeitverzögerungen durch eine Anzahl von seriell verbundenen Verzögerungselementen erzeugt werden, die durch das Steuerungssignal in der verzögert-verriegelten Schleife gesteuert sind.

16. Vorrichtung nach Anspruch 14, **dadurch gekennzeichnet, dass** jedes Verzögerungselement das Referenzsignal des Taktgebers um ein Zeitquantum verzögert, das 1/N-tel einer Taktperiode beträgt.

17. Vorrichtung nach einem der Ansprüche 12 bis 16, **dadurch gekennzeichnet, dass** der Verzögerungsschaltkreis N Verzögerungselemente aufweist, die jeweils eine zusätzliche Verzögerung um 1/N-tel der Taktperiode bewirken, wobei N digital zwischen wenigstens zwei vorbestimmten Werten einstellbar ist, die vorzugsweise aus den Werten 25, 30, 32, 36, 40, 50, 60, 64, 72, 80, 100, 120 und 128 auswählbar sind.

18. Vorrichtung nach einem der Ansprüche 12 bis 17, **dadurch gekennzeichnet, dass** der Verzögerungsschaltkreis in ECL-Technologie (Emitter Coupled Logic) hergestellt ist.

19. Vorrichtung nach einem der Ansprüche 12 bis 17, **dadurch gekennzeichnet, dass** der Verzögerungsschaltkreis in CMOS-Technologie (komplementäre Metalloxid-Halbleiter-Technologie) hergestellt ist.

20. Vorrichtung nach einem der Ansprüche 12 bis 19, **dadurch gekennzeichnet, dass** die Vorrichtung mittels einer Zeitverzögerung des Verzögerungsschaltkreises in den entsprechenden Taktperioden eine Adressauflösung für Musterelemente zur Verfügung stellt, die signifikant höher ist als diejenige des elektronischen Taktgebers.

21. Vorrichtung nach einem der Ansprüche 12 bis 19, **dadurch gekennzeichnet, dass** die Vorrichtung ein Mehrfachstrahl-Schreibgerät ist, wobei der Verzögerungsschaltkreis zum Verzögern der Eingangs-Taktsignale des elektronischen Taktgebers zum Einstellen eines Strahls relativ zu den anderen Strahlen ausgebildet ist.

22. Vorrichtung nach einem der Ansprüche 12 bis 19, **dadurch gekennzeichnet, dass** der Verzögerungsschaltkreis'benutzt wird, um die Eingangs-Taktsignale des elektronischen Taktgebers zum Feineinstellen der Platzierung des gesamten Musters in der Schreibrichtung zu verzögern.

## Revendications

1. Procédé d'écriture de motifs lithographiques au moyen d'une technique de balayage tramé, comprenant l'utilisation d'une horloge électronique pour commander la modulation du faisceau où le placement suivant les directions de balayage d'éléments de motifs est commandé par des retards temporels par fractions d'une période d'horloge, **caractérisé en ce que** ladite horloge est utilisée pour produire un nombre de valeurs de temps de retard qui sont, de préférence, uniformément séparées par l'intermédiaire d'une boucle asservie par retard et **en ce qu'**une valeur de temps de retard particulière est choisie en fonction d'un mot de commande numérique.²

2. Procédé selon la revendication 1, où le mot de commande numérique est modifié dynamiquement pendant l'écriture d'un motif.

3. Procédé selon la revendication 1 ou 2, **caractérisé en ce que** :
ledit circuit de retard temporel comprend une boucle asservie retardée, comprenant :
au moins N éléments de retard connectés en série, où N est le nombre entier plus grand que deux, qui retardent chacun un signal de référence venant de ladite horloge, d'un certain quantum de temps, et
un comparateur de phase connecté à la sortie du N^{ième} élément de retard afin de recevoir le signal retardé acheminé et le signal de référence, pour produire un signal de commande indicatif de la différence existant entre la phase dudit signal de retard acheminé et la phase dudit signal de référence, et un moyen de réaction servant à transférer le signal de commande aux éléments de retard, si bien que chacun des éléments de retard s'ajuste de façon que la phase du signal de référence soit synchronisée avec la phase dudit signal acheminé.

4. Procédé selon l'une quelconque des revendications précédentes, **caractérisé en ce que** lesdits retards temporels sont produits par un certain nombre d'éléments de retard connectés en série qui sont commandés par le signal de commande dans la boucle asservie retardée.

5. Procédé selon la revendication 3, **caractérisé en ce que** le signal d'horloge est connecté à des éléments de retard connectés en série qui sont commandés par ledit signal de commande et la sélection d'un certain nombre d'éléments de retard afin de retarder ledit signal d'horloge allant à la sortie en fonction dudit mot de commande numérique.

6. Procédé selon l'une quelconque des revendications précédentes, **caractérisé en ce que** le circuit de retard comprend N éléments de retard, qui fournissent chacun un retard supplémentaire de 1/N de la période d'horloge, où N est numériquement ajustable entre au moins deux valeurs prédéterminées, de préférence choisies entre les valeurs 25, 30, 32, 36, 40, 50, 60, 64, 72, 80, 100, 120 et 128.

7. Procédé selon l'une quelconque des revendications précédentes, **caractérisé en ce que** la période d'horloge est divisée en N incréments (pas), où N est un nombre tel que N = 2ₙ, n étant un entier positif, si bien qu'une période de temps quelconque peut être représentée numériquement au moyen d'un mot binaire pour le nombre de périodes d'horloge complètes et d'un mot binaire pour le retard supplémentaire sous la forme d'un nombre de fractions 1/N d'une période d'horloge.

8. Procédé selon l'une quelconque des revendications 1 à 7,
**caractérisé en ce que** le circuit de retard est utilisé pour produire une résolution d'adressage pour les éléments de motif qui est suffisamment supérieure à celle qui est donnée par l'horloge électronique, par un retard temporel des périodes d'horloge respectives.

9. Procédé selon l'une quelconque des revendications 1 à 7, **caractérisé en ce que** le circuit de retard est utilisé pour retarder le signal d'horloge d'entrée de l'horloge électronique pour certains composants logiques.

10. Procédé selon la revendication 9, **caractérisé en ce que** les composants logiques sont des composants permettant d'ajuster le faisceau par rapport à d'autres faisceaux dans le cas d'une écriture par faisceaux multiples.

11. Procédé selon la revendication 9, **caractérisé en ce que** les composants logiques sont des composants servant à placer suivant un ajustement fin le motif global suivant la direction de balayage.

12. Appareil conçu pour écrire des motifs lithographiques au moyen d'une technique de balayage tramé, comprenant une horloge électronique et un circuit de retard temporel, **caractérisé en ce que** le circuit de retard temporel est un circuit à boucle asservie retardée, excité par ladite horloge, si bien que le signal de sortie du circuit de retard est déterminé par des données d'entrée.

13. Appareil selon la revendication 12, par le moyen duquel il est prévu d'écrire des motifs complexes sur une surface sensible à la lumière par balayage d'au moins un, par un faisceau laser modulé par modulateur, sur des lignes de balayage parallèles tout en se déplaçant suivant des bandes de balayage dans une direction perpendiculaire aux lignes de balayage, l'appareil comprenant :
un moyen de délivrance de données servant à commander l'entrée dudit démodulateur tandis que le faisceau laser est en train d'effectuer un balayage, où le moyen de délivrance de données comprend :
une horloge ayant une période d'horloge prédéterminée entre les impulsions d'horloge ;
une unité de traitement de données servant à recevoir des données d'entrée et à calculer des données d'intensité de faisceau et des données de position de faisceau qui sont chacune suivant un format numérique, pour un bord du motif ;
une unité de traitement de signaux servant à convertir les données de position de faisceau en un temps équivalent afin de positionner le faisceau laser suivant la ligne de balayage pendant le balayage, et à convertir ce temps équivalent en un nombre entier d'impulsions d'horloge plus un reste fractionnaire ; et
un circuit de retard temporel servant à retarder la transition dans les données modulées, en produisant ledit reste fractionnaire, pour une résolution d'adressage supérieure à celle qui correspond aux impulsions d'horloge de données.

14. Appareil selon la revendication 12 ou 13, **caractérisé en ce que** ledit circuit de retard temporel comprend une boucle asservie retardée, comprenant :
N éléments de retard connectés en série, où N est un entier supérieur à deux, qui retardent chacun un signal de référence venant de ladite horloge, d'un quantum de temps,
un comparateur de phase connecté à la sortie du N^{ième} élément de retard afin de recevoir le signal retardé acheminé et le signal de référence, pour produire un signal de référence indicatif de la différence entre la phase dudit signal de retard acheminé et la phase dudit signal de référence, et étant connecté en réaction auxdits éléments de retard pour transférer le signal de commande aux éléments de retard, si bien que chacun des éléments de retard s'ajuste de façon que la phase dudit signal de référence soit synchronisée avec la phase dudit signal de retard acheminé,
un multiplexeur qui est commandé aux éléments de retard afin de recevoir les signaux retardés produits par les éléments de retard et pour commander le signal de sortie du circuit de retard en fonction du reste fractionnaire voulu.

15. Appareil selon l'une quelconque des revendications 12 à 14, **caractérisé en ce que** lesdits retards temporels sont produits par un certain nombre d'éléments de retard connectés en série qui sont commandés par le signal de commande dans la boucle asservie retardée.

16. Appareil selon la revendication 14, **caractérisé en ce que** chaque élément de retard retarde le signal de référence venant de ladite horloge d'un quantum de temps qui est de 1/N fois une période d'horloge.

17. Appareil selon l'une quelconque des revendications 12 à 16, **caractérisé en ce que** le circuit de retard comprend N éléments de retard qui produisent chacun un retard supplémentaire valant 1/N fois la période d'horloge, si bien que N est numériquement ajustable entre au moins deux valeurs prédéterminées, qui sont de préférence choisies entre les valeurs 20, 30, 32, 36, 40, 50, 60, 64, 72, 80, 100, 120 et 128.

18. Appareil selon l'une quelconque des revendications 12 à 17, **caractérisé en ce que** le circuit de retard est produit au moyen d'une technologie ECL (logique à couplage par les émetteurs).

19. Appareil selon l'une quelconque des revendications 12 à 17, **caractérisé en ce que** le circuit de retard est produit au moyen d'une technique CMOS (transistors métal-oxyde-semiconducteur complémentaires).

20. Appareil selon l'une quelconque des revendications 12 à 19, **caractérisé en ce que** l'appareil produit une résolution d'adressage dans les éléments de motifs qui est sensiblement supérieure à celle qui est donnée par l'horloge électronique par l'intermédiaire d'un retard temporel venant dudit circuit de retard dans les périodes d'horloge respectives.

21. Appareil selon l'une quelconque des revendications 12 à 19, **caractérisé en ce que** l'appareil est un moyen d'écriture à plusieurs faisceaux, où le circuit de retard est conçu pour retarder les signaux d'horloge d'entrée de l'horloge électronique afin d'ajuster un faisceau par rapport aux autres faisceaux.

22. Appareil selon l'une quelconque des revendications 12 à 19, **caractérisé en ce que** le circuit retardateur est utilisé pour retarder les signaux d'horloge d'entrée de l'horloge électronique afin d'ajuster de manière fine le placement du motif global suivant la direction d'écriture.
